# EUROPÄISCHE PATENTSCHRIFT

(11) **EP 1 352 432 B1**
(45) Veröffentlichungstag und Bekanntmachung des Hinweises auf die Patenterteilung: **15.06.2011**
(21) Anmeldenummer: 02702216.9
(22) Anmeldetag: 15.01.2002
(51) Int. Cl.: H01L 33/64, H01L 33/58

(54) **LUMINESZENZDIODE UND VERFAHREN ZU DEREN HERSTELLUNG**
LIGHT-EMITTING DIODE AND METHOD FOR THE PRODUCTION THEREOF
DIODE LUMINESCENTE ET PROCEDE PERMETTANT DE LA PRODUIRE

(30) Priorität: 15.01.2001 DE 10101554
(43) Veröffentlichungstag der Anmeldung: 15.10.2003
(73) Patentinhaber: OSRAM Opto Semiconductors GmbH, 93055 Regensburg (DE)
(72) Erfinder: BAUR, Johannes, 93180 Deuerling (DE); EISERT, Dominik, 93049 Regensburg (DE); FEHRER, Michael, 93077 Bad Abbach (DE); HAHN, Berthold, 93155 Hemau (DE); HÄRLE, Volker, 93164 Waldetzenberg (DE); JACOB, Ulrich, 93053 Regensburg (DE); PLASS, Werner, 93047 Regensburg (DE); STRAUSS, Uwe, 93077 Bad Abbach (DE); VÖLKL, Johannes, 91056 Erlangen (DE); ZEHNDER, Ulrich, 93049 Regensburg (DE)
(74) Vertreter: Epping - Hermann - Fischer
(86) Internationale Anmeldenummer: PCT/DE2002/000092
(87) Internationale Veröffentlichungsnummer: WO 2002/056390

(56) Entgegenhaltungen:
- EP-A- 0 809 304
- EP-A- 0 933 823
- EP-A- 1 191 608
- EP-A2- 1 191 608
- WO-A-00/65665
- WO-A-02/07229
- WO-A-97/28565
- WO-A-99/14810
- WO-A1-99/14810
- DE-A- 1 589 274
- DE-A- 2 634 330
- FR-A- 1 416 993
- JP-A- 07 007 184
- JP-A- 07 007 184
- JP-A- 09 129 935
- JP-A- 09 129 935
- US-A- 5 528 474
- PATENT ABSTRACTS OF JAPAN vol. 014, no. 373 (M-1009), 13. August 1990 (1990-08-13) & JP 02 134260 A (SEIKO EPSON CORP), 23. Mai 1990 (1990-05-23)
- PATENT ABSTRACTS OF JAPAN vol. 1995, no. 10, 30. November 1995 (1995-11-30) -& JP 07 169994 A (SHARP CORP), 4. Juli 1995 (1995-07-04)
- PATENT ABSTRACTS OF JAPAN vol. 016, no. 408 (E-1255), 28. August 1992 (1992-08-28) & JP 04 137674 A (TOSHIBA LIGHTING CO), 12. Mai 1992 (1992-05-12)
- PATENT ABSTRACTS OF JAPAN vol. 010, no. 255 (E-433), 2. September 1986 (1986-09-02) & JP 61 082486 A (SHARP CORP), 26. April 1986 (1986-04-26)

## Beschreibung

Die Erfindung betrifft eine Lumineszenzdiode mit einem Halbleiterchip, der eine auf einem Substrat ausgebildete, Photonen emittierende aktive Schicht und eine nachgeordnete Kontaktschicht aufweist, die zumindest für einen Teil der Photonen durchlässig ist. Sie betrifft weiterhin ein Verfahren zum Herstellen der Lumineszenzdiode.

Eine derartige Lumineszenzdiode ist aus der US 5,432,808 A bekannt. Die Lumineszenzdiode weist einen Halbleiterchip auf, der über ein elektrisch leitendes, dotiertes Substrat aus SiC verfügt. Auf das Substrat ist eine Schicht mit der Zusammensetzung GaₓAl_{y}In_{1-x-y}yN aufgebracht wobei 0 ≤ x ≤ 1 und 0 ≤ y ≤ 1 gilt. Der Halbleiterchip ist auf einen Trägerkörper aufgebracht und über Bonddrähte mit äußeren Anschlußleitungen verbunden. Außerdem ist der Halbleiterchip in eine Schutzhülle aus Kunstharz eingebettet, die gleichzeitig als Linse dient. Ein Nachteil der bekannten Lumineszenzdiode ist die fehlende Beständigkeit der Schutzhülle gegen Strahlung mit hoher Photonenenergie, da die Halbleiterchips auf der Basis GaAlInN Licht im UV-Bereich bis zum kurzwelligen grünen Wellenlängenbereich emittieren. Auch das Problem der Wärmeabführung ist bei der bekannten Lumineszenzdiode bei Leistungsanwendungen nicht ausreichend gelöst, da Kunstharz im allgemeinen einen schlechten Wärmeleiter darstellt.

In der Druckschrift EP 0809304A2 wird ein strahlungsemittierender Halbleiterchip beschrieben, der in einer Vertiefung eines Linsenkörpers aus SiC, Al₂O₃ oder Glas angeordnet ist.

In der Druckschrift JP 09129935 wird ein strahlungsemittierender Halbleiterchip beschrieben, der in ein Linsenkörper aus einem transluzenten Material eingebettet ist, wobei an dem Linsenkörper aus dem transluzenten Material ein Kühlkörper angebracht ist.

In der Druckschrift JP 07007184 wird ein strahlungsemittierender Halbleiterchip mit einem Linsenkörper beschrieben, wobei zwisschen dem Halbleiterchip und dem Linsenkörper ein Kühlkörper angeordnet ist.

In der Druckschrift EP 1191608 A2 wird ein strahlungsemittierender Halbleiterchip beschrieben, der an einem Linsenkörper aus SiC, Al₂O₃ oder Glas angebracht ist.

Ausgehend von diesem Stand der Technik liegt der Erfindung die Aufgabe zugrunde, eine Licht im UV-Bereich emittierende Lumineszenzdiode zu schaffen, die sich für Leistungsanwendungen eignet. Weiterhin soll ein Verfahren zu deren Herstellung angegeben werden.

Diese Aufgabe wird durch eine Lumineszenzdiode mit den Merkmalen des Patentanspruches 1 bzw. durch ein Verfahren mit den Merkmalen des Anspruches 18 gelöst. Verschiedene vorteilhafte Weiterbildungen und Ausführungsformen weisen zusätzliche Merkmale gemäß den Unteransprüchen auf.

Gemäß der Erfindung ist an der strahlungsdurchlässigen Kontaktschicht des Halbleiterchips ein die Verlustwärme aus der aktiven Schicht abführender, für die emittierten Photonen transparenter Linsenkörper aus SiC, Al₂O₃, Glas oder einem Granatkristall angeordnet, wobei an dem Linsenkörper ein Kühlkörper angebracht ist.

Bei einer Lumineszenzdiode gemäß der Erfindung ist der transparente Linsenkörper aus SiC, Al₂O₃, Glas oder einem Granatkristall gefertigt, wobei an dem Linsenkörper ein Kühlkörper eingebracht ist. Deren Materialeigenschaften ändern sich auch nicht durch die Bestrahlung mit UV-Licht. Außerdem weisen diese Materialien im Vergleich zu Kunstharz eine gute Wärmeleitfähigkeit auf und sind daher geeignet, den Halbleiterchip auch im Leistungsbetrieb, bei hohen elektrischen und hohen Lichtleistungen zu kühlen.

Bei dem erfindungsgemäßen Verfahren wird der Halbleiterchip mittels Laserlöten durch den Linsenkörper hindurch, insbesondere über eine auf dem Linsenkörper befindliche Leiterbahn, mit dem Linsenkörper verbunden.

Dabei werden folgende Verfahrensschritte durchgeführt:
(a) Herstellen einer Mehrzahl von Linsenkörpern aus SiC, Al₂O₃, Glas oder einem Granatkristall in einem Waferverbund;
(b) Aufbringen von elektrischen Leiterbahnen für eine Mehrzahl von Halbleiterchips auf die Seite des Waferverbunds, auf der die Halbleiterchips später montiert werden;
(c) Befestigen einer Mehrzahl von Halbleiterchips an den Leiterbahnen, wobei die Halbleiterchips an ihren strahlungsdurchlässigen elektrischen Kontaktschichten mittels Laserlöten durch den Waferverbund hindurch mit den Leiterbahnen verbunden werden; und
(d) Zerteilen des Waferverbundes in kleinere Linsenkörpereinheiten oder in einzelne Linsenkörper mit Halbleiterchips.
(e) Anbringen eines Kühlkörpers an den Linsenkörper.

Weiterhin bevorzugt werden zwischen den Schritten (c) und (d) elektrische Leiterbahnen zum elektrischen Anschließen von Rückseitenkontakten der Halbleiterchips auf den Waferverbund aufgebracht.

Weitere Vorteile und vorteilhafte Weiterbildungen der Erfindung ergeben sich aus den nachfolgend in Verbindung mit den Figuren 1 bis 6 erläuterten Ausführungsbeispielen. Es zeigen:
- Figur 1: eine schematische Darstellung eines Querschnitts durch eine Lumineszenzdiode;
- Figur 2: eine schematische Darstellung eines Querschnitts durch ein abgewandeltes Ausführungsbeispiel der Lu- mineszenzdiode aus Figur 1;
- Figur 3: eine schematische Darstellung einer Aufsicht von unten auf die Lumineszenzdiode aus Figur 2;
- Figur 4: eine schematische Darstellung eines Querschnitts durch ein weiteres abgewandeltes Ausführungsbei- spiel der Lumineszenzdiode;
- Figur 5: eine schematische Darstellung einer Aufsicht von unten auf die Lumineszenzdiode aus Figur 4;
- Figur 6: eine schematische Darstellung eines Querschnitts durch eine Lumineszenzdiode, die mit einem Gehäuse ausgestattet ist, das mit einem Gewinde versehen ist.

Gleiche oder gleich wirkende Bestandteile der Ausführungsbeispiele sind in den Figuren jeweils mit denselben Bezugszeichen versehen.

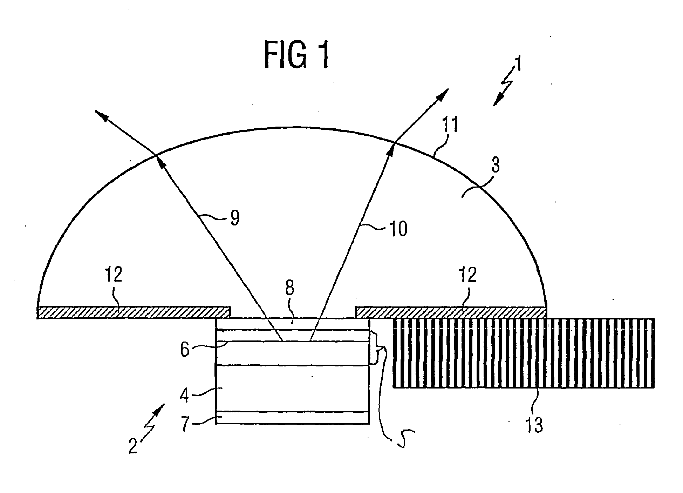

Die Lumineszenzdiode von Figur 1 verfügt über einen Halbleiterchip 2 und einen daran angebrachten Linsenkörper 3. Der Halbleiterchip 2 weist ein Substrat 4 auf, auf dem eine aktive Schicht 5 mit einem pn-Übergang 6, einer Single-Quanten-Well- oder einer Multi-Quanten-Well-Struktur ausgebildet ist. Die aktive Schicht 5 ist beispielsweise auf der Basis von GaₓAl_{y}In_{1-x-y}N hergestellt, wobei 0 ≤ x ≤ 1, 0 ≤ y ≤ 1 und x+y ≤ 1 gilt. Auf der Rückseite des Substrats 4 ist eine n-seitige Kontaktschicht 7 ausgebildet, die vorzugsweise reflektierend ausgebildet ist. Auf der Vorderseite des Halbleiterchips 2 ist schließlich eine für von der aktiven Schicht 5 ausgesandte Photonen durchlässige p-seitige Kontaktschicht 8 angeordnet, an der der Linsenkörper 3 anliegt oder zu dieser physikalischen Kontakt aufweist. Die p-seitige Kontaktschicht 8 besteht beispielsweise aus einer ca. 6 nm dicken Platinschicht, aus einer insel- oder netzartigen metallischen Struktur, aus Indium-Zinn-Oxid (ITO) oder aus ZnO.

Der Linsenkörper 3, hier eine Plan-Konvex-Linse, an dessen planen Seite der Halbleiterchip 2 derart angeordnet ist, dass die von ihm emittierten Photonen in den Linsenkörper 3 eingekoppelt werden, ist aus einem lichtbeständigen anorganischen Feststoff hergestellt, der in der Lage ist, eine Verlustwärme aus der aktiven Schicht 5 abzuführen.

Unter lichtbeständig ist in diesem Zusammenhang zu verstehen, daß der Feststoff über die Lebensdauer der Lumineszenzdiode 1 hinweg keine Änderung des Absorptionskoeffizienten um mehr als 10 % aufweist. Derartige Stoffe sind beispielsweise SiC, Al₂O₃ sowie Glas und Granatkristalle.

Die von der aktiven Schicht 5 emittierten Photonen, deren Weg durch den Chip und den Linsenkörper in Figur 1 durch Lichtstrahlen 9 und 10 (Brechungseffekte sind in dieser Darstellung vernachlässigt) veranschaulicht ist, können durch die p-seitige Kontaktschicht 8 und den Linsenkörper 3 hindurchtreten und diesen an einer Leuchtfläche 11 verlassen. Da sich die optischen Eigenschaften des Linsenkörpers 3 über die Lebensdauer der Lumineszenzdiode 1 nur wenig ändern, ist über die Lebensdauer der Lumineszenzdiode 1 hinweg eine gute Auskoppeleffizienz gewährleistet.

Auf der dem Halbleiterchip 2 zugewandten planen Seite des Linsenkörpers 3 sind Leiterbahnen 12 ausgebildet. Außerdem kann auf der Unterseite des Linsenkörpers 3 ein Kühlkörper 13 angeordnet sein, der dazu dient, die von dem Chip 2 an den Linsenkörper 3 abgegebene Wärme aus dem Linsenkörper 3 wieder abzuführen.

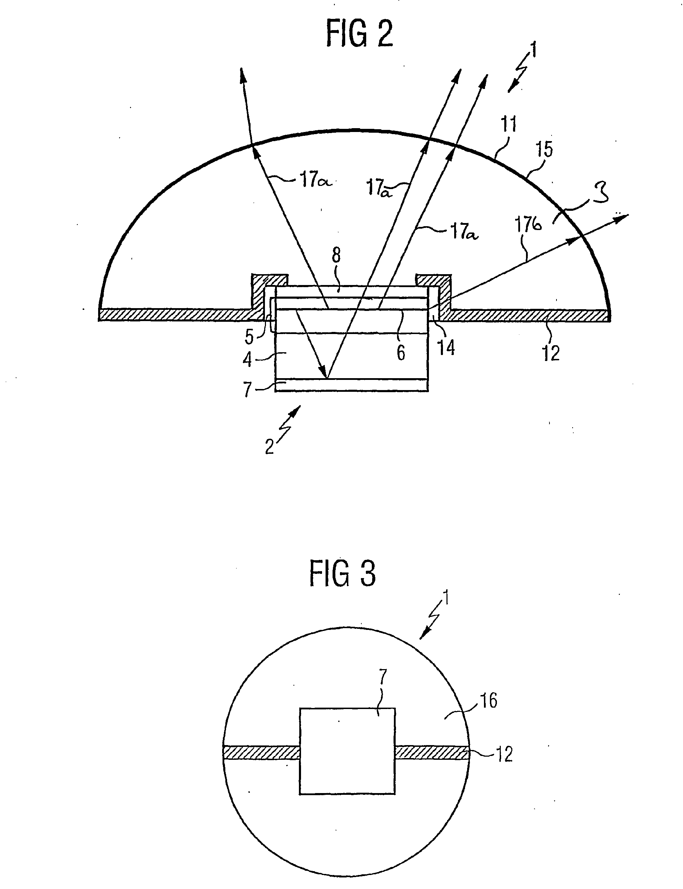

Das in Figur 2 dargestellt abgewandelte Ausführungsbeispiel der Lumineszenzdiode 1, weist der Linsenkörper 3 an der "planen" Seite eine Vertiefung 14 auf, in die der Halbleiterchip 2 derart eingebracht ist, daß die aktive Schicht 6 zum großen Teil innerhalb der Vertiefung 14 zu liegen kommt. Insbesondere ist die Vertiefung 14 so ausgebildet, daß der pn-Übergang 6 innerhalb der Vertiefung liegt, so daß seitlich aus dem Halbleiterchip 2 austretendes Licht 17b vom Linsenkörper 3 aufgenommen werden kann.

Ferner ist es möglich, auf der Leuchtfläche 11 des Linsenkörpers 3 eine Antireflexionsschicht 15 vorzusehen, die den Sprung des Brechungsindex an der Leuchtfläche 11 verringert und damit die Auskoppelung des Lichts aus dem Linsenkörper 3 erleichtert. Die Antireflexionsschicht 15 ist zweckmäßigerweise aus einem Dielektrikum hergestellt. Die Antireflexionsschicht 15 kann auch einen oder mehrere optisch aktive Konversionsstoffe enthalten, die Licht einer bestimmten Wellenlänge in Licht umwandeln, das eine größere Wellenlänge besitzt. Diese Konversionsstoffe können auch im Linsenkörper 3 selbst eingebettet sein.

Ferner ist, wie in Figur 3 gezeigt, bei der Lumineszenzdiode 1 gemäß dem Ausführungsbeispiel von Figur 2 auf der Unterseite eine Reflexionsschicht 16 vorgesehen, die sich über die von der Leiterbahn 12 nicht bedeckte Unterseite des Linsenkörpers 3 erstreckt. Diese Reflexionsschicht 16 kann alternativ auch ganzflächig auf die außerhalb der Vertiefung 14 liegende Fläche der "planen" Seite des Linsenkörpers aufgebracht sein. In diesem Fall befindet sich zwischen den Leiterbahnen 12 und dem Linsenkörper 3 eine Reflexionsschicht, wodurch eine Absorption an den Leiterbahnen 12 weitestgehend vermindert wird.

Durch die Spiegelschicht 16 werden Lichtstrahlen, die nicht, wie die in Figur 2 dargestellten Lichtstrahlen 17a,b beim ersten Auftreffen auf die konvexe Seite des Linsenkörpers 3, das heißt aus der Leuchtfläche 11 auskoppeln, sondern an dieser zurückreflektiert werden, von der Spiegelschicht 16 in den Linsenkörper 3 zurückgeworfen, so daß sie unter Umständen beim zweiten Auftreffen auf die Leuchtfläche 11 aus dem Linsenkörper 3 auskoppeln können.

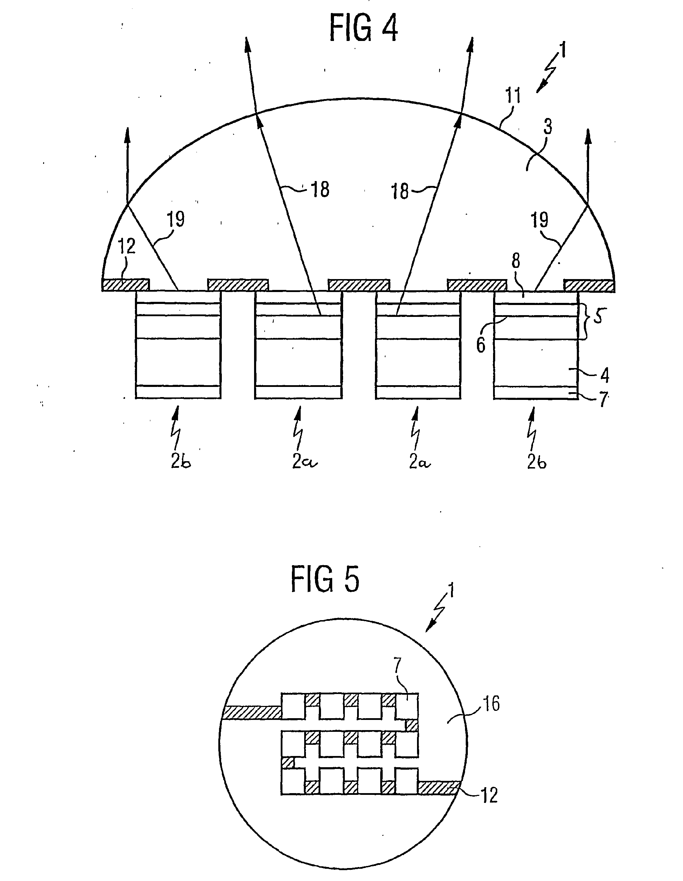

Die Figur 4 zeigt ein abgewandeltes Ausführungsbeispiel, bei dem eine Mehrzahl von Halbleiterchips 2 an der Unterseite des Linsenkörpers 3 befestigt ist. Lichtstrahlen, die von den innenliegenden Halbleiterchips 2a ausgehen, wie die in Figur 4 eingezeichneten Lichtstrahlen 18, weisen hierbei eine höhere Auskoppelwahrscheinlichkeit auf als die von äußeren Halbleiterchips 2b ausgehenden Lichtstrahlen 19, da diese unter ungünstigeren Winkeln auf die Leuchtfläche 11 auftreffen. Dieser Nachteil kann aber beispielsweise durch eine Reflexionsschicht 16 an der "planen" Seite des Linsenkörpers 3, an der diese Lichtstrahlen wieder zur konvexen Linsenfläche hin reflektiert werden, zumindest teilweise gemindert werden.

In Figur 5 ist eine Aufsicht von unten auf die Lumineszenzdiode 1 gemäß Figur 4 dargestellt, aus der eine serielle Kontaktierung der Halbleiterchips 2 über die Leiterbahn 12 ersichtlich ist. Es ist auch denkbar, die Leiterbahn 12 netzartig auszubilden, um durch Parallelschaltung eine gleichmäßige Betriebsspannung an den Halbleiterchips zu gewährleisten.

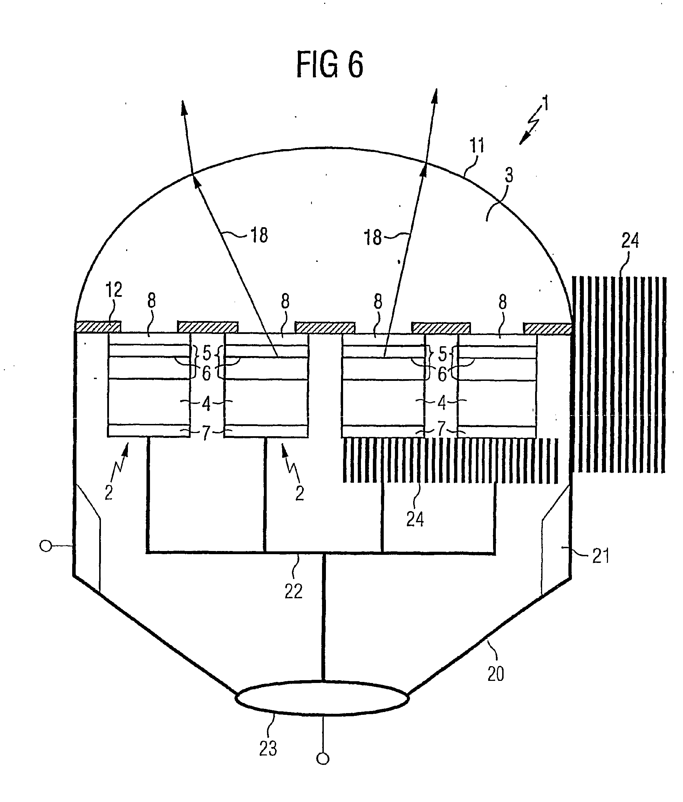

Die in den Figuren 1 bis 5 dargestellten Lumineszenzdioden 1 können auch, wie in Figur 6 für das Ausführungsbeispiel gemäß Figur 4 beispielhaft dargestellt, mit einem Gehäuse 20 versehen sein, das beispielsweise über ein Gewinde 21 in eine herkömmliche Lampenfassung einschraubbar ist.

Es kann aber für das Gehäuse 20 auch eine beliebige andere geeignete Anschlußtechnologie, wie beispielsweise die in der Halbleitertechnik verbreitete Oberflächenmontagetechnik gewählt sein.

Bei dem in Figur 6 dargestellten Ausführungsbeispiel ist das Gehäuse 20 über die Leiterbahn 12 mit den p-seitigen Kontaktschichten 8 der Halbleiterchips 2 verbunden. Die n-seitigen Kontaktschichten sind über eine separate Leitung 22 mit einem gegenüber dem Gehäuse 20 isolierten Anschlußkontakt 23 verbunden.

Bei dem in Figur 6 dargestellten Ausführungsbeispiel der Lumineszenzdiode 1 kann die Wärme sowohl über den Linsenkörper 3 an das umgebende Medium, im allgemeinen Luft, oder an dem am Linsenkörper angebrachten Kühlkörper (nicht dargestellt) abgegeben werden. Die Wärme kann auch über das Gehäuse 20, wobei am Gehäuse 20 zusätzliche Kühlkörper 24 vorgesehen sein können, die mit den Anschlußkontakten 12 und 7 verbunden sind und zusätzliche Wärmesenken darstellen.

Die in Figur 6 dargestellte Lumineszenzdiode eignet sich insbesondere als Ersatz für herkömmliche Glühlampen, wobei das Volumen der Lumineszenzdiode 1 bei gleicher Lichtleistung wesentlich kleiner als das Volumen herkömmlicher Glühlampen ist.

Die bei einzelnen Ausführungsbeispielen konkret beschriebenen zusätzlichen vorteilhaften technischen Elemente können selbstverständlich, soweit möglich, bei allen anderen Ausführungsbeispielen realisiert werden. So ist zum Beispiel auch beim Ausführungsbeispiel gemäß Figur 1 die Verwendung einer Reflexionsschicht 16 gemäß dem Ausführungsbeispiel der Figuren 2 und 3 einsetzbar.

Die Beschreibung der Erfindung anhand der Ausführungsbeispiele ist selbstverständlich auch nicht als Beschränkung der Erfindung auf diese Ausführungsbeispiele zu verstehen.

Bei einem bevorzugten Verfahren zum Herstellen einer erfindungsgemäßen Lumineszenzdiode wird der Halbleiterchip 2 mittels Laserlöten durch den Linsenkörper 3 hindurch mit der elektrischen Leiterbahn 12 verbunden. Hierbei wird vorzugsweise zunächst eine Mehrzahl von Linsenkörpern 3 im Waferverbund gefertigt. Vor dem Zerteilen dieses Waferverbundes in einzelne kleinere Linsenkörpereinheiten oder einzelne Linsenkörper 3 werden auf der der Abstrahlungsseite der Linsenkörper 3 abgewandten Seite des Waferverbündes die Halbleiterchips 2 auf dem Waferverbund mittels Laserlöten befestigt, indem ihre Kontaktschichten 8 mit den Leiterbahnen 12, beispielsweise Metallisierungsschichten, durch den Waferverbund hindurch laserverlötet werden. Vorzugsweise werden vor dem Zerteilen des Waferverbundes auch noch elektrische Leiterbahnen 22 zum Anschließen der rückseitigen Kontakte 7 der Halbleiterchips 2 auf den Linsenkörper-Waferverbund aufgebracht.

## Patentansprüche

1. Lumineszenzdiode mit einem Halbleiterchip (2), der eine auf einem Substrat (4) ausgebildete, Photonen emittierende aktive Schicht (5) und eine, gesehen vom Substrat (4) der aktiven Schicht (5) nachgeordnete strahlungsdurchlässige elektrische Kontaktschicht (8) aufweist,
wobei an der strahlungsdurchlässigen elektrischen Kontaktschicht (8) ein die Verlustwärme aus der aktiven Schicht (5) abführender, für die emittierten Photonen transparenter Linsenkörper (3) aus SiC, Al₂O₃, Glas oder einem Granatkristall angeordnet ist,
**dadurch gekennzeichnet, daß** an dem Linsenkörper (3) ein Kühlkörper (13) angebracht ist.

2. Lumineszenzdiode nach Anspruch 1,
**dadurch gekennzeichnet, daß** der Linsenkörper (3) mit einer die Kontaktschicht (8) kontaktierenden Leiterbahn (12) versehen ist.

3. Lumineszenzdiode nach Anspruch 1 oder 2,
**dadurch gekennzeichnet, daß** der Linsenkörper (3) die Form eines Kugelsegments aufweist.

4. Lumineszenzdiode nach einem der Ansprüche 1 bis 3,
**dadurch gekennzeichnet, daß** der Linsenkörper (3) auf einer Leuchtfläche (11) eine Antireflexionsschicht (15) aufweist.

5. Lumineszenzdiode nach einem der Ansprüche 1 bis 3,
**dadurch gekennzeichnet, daß** eine Schicht (15) auf einer Leuchtfläche (11) des Linsenkörpers (3) optische Konversionsstoffe enthält.

6. Lumineszenzdiode nach einem der Ansprüche 1 bis 5,
**dadurch gekennzeichnet, daß** der Halbleiterchip (2) in einer Vertiefung (14) des Linsenkörpers (3) angebracht ist.

7. Lumineszenzdiode nach Anspruch 6,
**dadurch gekennzeichnet, daß** in seitliche Richtung emittierende Bereiche (6) der aktiven Schicht (5) innerhalb der Vertiefung (14) liegen, derart, dass von den seitlich emittierenden Bereichen (6) der aktiven Schicht (5) ausgehende Photonen (17b) in den Linsenkörper (3) einkoppeln.

8. Lumineszenzdiode nach einem der Ansprüche 1 bis 7,
**dadurch gekennzeichnet, daß** eine dem Halbleiterchip (2) zugewandte Rückseite des Linsenkörpers (3) wenigstens teilweise verspiegelt ist.

9. Lumineszenzdiode nach einem der Ansprüche 1 bis 8,
**dadurch gekennzeichnet, daß** die aktive Schicht (5) auf der Basis von GaₓAl_{y}In_{1-x-y}yN hergestellt ist, wobei 0 ≤ x ≤ 1, 0 ≤ y ≤ 1 und x+y ≤ 1 gilt.

10. Lumineszenzdiode nach einem der Ansprüche 1 bis 9,
**dadurch gekennzeichnet, daß** eine Vielzahl von Halbleiterchips (2) nebeneinander an dem Linsenkörper (3) angebracht ist.

11. Lumineszenzdiode nach einem der Ansprüche 1 bis 10,
**dadurch gekennzeichnet, daß** die Lumineszenzdiode mit einem Gehäuse (20) versehen ist, das zum Einschrauben in eine Lampenfassung mit einem Gewinde (21) ausgestattet ist.

12. Lumineszenzdiode nach einem der Ansprüche 1 bis 10,
**dadurch gekennzeichnet, daß** die Lumineszenzdiode ein oberflächenmontierbares Gehäuse (20) aufweist.

13. Lumineszenzdiode nach einem der Ansprüche 1 bis 12,
**dadurch gekennzeichnet, daß** der Halbleiterchip (2) unter anderem Strahlung aus dem ultravioletten Spektralbereich aussendet.

14. Lumineszenzdiode nach einem der Ansprüche 1 bis 13,
**dadurch gekennzeichnet, daß** der Halbleiterchip (2) auf der vom Linsenkörper (3) abgewandten Seite eine reflektierende Schicht (7) aufweist.

15. Lumineszenzdiode nach Anspruch 10 oder nach einem der Ansprüche 11 bis 14 unter Rückbezug auf Anspruch 10,
**dadurch gekennzeichnet, daß** alle Halbleiterchips (2a,2b) in Vertiefungen (14) angeordnet sind.

16. Lumineszenzdiode nach Anspruch 9 oder nach einem der Ansprüche 10 bis 15 unter Rückbezug auf Anspruch 9,
**dadurch gekennzeichnet, daß** das Substrat ein elektrisch leitendes Substrat ist, über das einer der elektrischen Anschlüsse der aktiven Schicht hergestellt ist.

17. Lumineszenzdiode nach Anspruch 16,
**dadurch gekennzeichnet, daß** das Substrat ein dotiertes SiC-Substrat list.

18. Verfahren zum Herstellen einer Lumineszenzdiode gemäß einem der Ansprüche 1 bis 17 mit den Verfahrensschritten:
(a) Herstellen einer Mehrzahl von Linsenkörpern (3) aus SiC, Al₂O₃, Glas oder einem Granatkristall in einem Waferverbund;
(b) Aufbringen von Leiterbahnen (12) für eine Mehrzahl von Halbleiterchips (2) auf die Seite des Waferverbunds, auf der die Halbleiterchips später montiert werden;
(c) Befestigen einer Mehrzahl von Halbleiterchips an den Leiterbahnen (12), wobei die Halbleiterchips (2) an ihren strahlungsdurchlässigen elektrischen Kontaktschichten (8) mittels Laserlöten durch den Waferverbund hindurch mit den Leiterbahnen (12) verbunden werden; und
(d) Zerteilen des Waferverbundes in kleinere Linsenkörpereinheiten oder in einzelne Linsenkörper (3) mit Halbleiterchips (2),
(e) Anbringen eines Kühlkörpers (13) an den Linsenkörper (3).

19. Verfahren nach Anspruch 18, bei dem zwischen den Schritten (c) und (d) elektrische Leiterbahnen (22) zum elektrischen Anschließen von Rückseitenkontakten (7) der Halbleiterchips (2) auf den Waferverbund aufgebracht werden.

## Claims

1. Light-emitting diode having a semi-conductor chip (2) which comprises an active layer (5), which is formed on a substrate (4) and emits photons, and an electric contact layer (8) which is radiation-permeable and as seen from the substrate (4) is disposed downstream of the active layer (5),
wherein a lens body (3) which is produced from SiC, Al₂O₃, glass or a garnet crystal and is transparent to the emitted photons and dissipates the lost heat from the active layer (5) is arranged at the radiation-permeable electric contact layer (8),
**characterised in that** a cooling body (13) is attached to the lens body (3).

2. Light-emitting diode as claimed in claim 1, **characterised in that** the lens body (3) is provided with a conductor track (12) which contacts the contact layer (8).

3. Light-emitting diode as claimed in claim 1 or 2, **characterised in that** the lens body (3) is in the form of a spherical segment.

4. Light-emitting diode as claimed in any one of claims 1 to 3, **characterised in that** the lens body (3) comprises an anti-reflection layer (15) on a luminescent surface (11).

5. Light-emitting diode as claimed in any one of claims 1 to 3, **characterised in that** a layer (15) on a luminescent surface (11) of the lens body (3) contains optical conversion materials.

6. Light-emitting diode as claimed in any one of claims 1 to 5, **characterised in that** the semi-conductor chip (2) is attached in an indentation (14) in the lens body (3).

7. Light-emitting diode as claimed in claim 6, **characterised in that** regions (6) of the active layer (5) which emit in a lateral direction lie within the indentation (14) in such a way that photons (17b) issuing from the laterally emitting regions (6) of the active layer (5) couple into the lens body (3).

8. Light-emitting diode as claimed in any one of claims 1 to 7, **characterised in that** a rear side of the lens body (3) facing the semi-conductor chip (2) is at least partially reflectively coated.

9. Light-emitting diode as claimed in any one of claims 1 to 8, **characterised in that** the active layer (5) is produced on the basis of GaₓAl_{y}In_{1-x-y}yN wherein 0 ≤ x ≤ 1, 0≤y≤1 and x+y ≤1.

10. Light-emitting diode as claimed in any one of claims 1 to 9, **characterised in that** a plurality of semi-conductor chips (2) are attached next to each other to the lens body (3).

11. Light-emitting diode as claimed in any one of claims 1 to 10, **characterised in that** the light-emitting diode is provided with a housing (20) which is equipped with a thread (21) for screwing into a lamp holder.

12. Light-emitting diode as claimed in any one of claims 1 to 10, **characterised in that** the light-emitting diode has a surface-mountable housing (20).

13. Light-emitting diode as claimed in any one of claims 1 to 12, **characterised in that** the semi-conductor chip (2) emits, amongst others, radiation from the ultraviolet spectral range.

14. Light-emitting diode as claimed in any one of claims 1 to 13, **characterised in that** the semi-conductor chip (2) has a reflective layer (7) on the side facing away from the lens-body (3).

15. Light-emitting diode as claimed in claim 10 or as claimed in any one of claims 11 to 14 with reference back to claim 10, **characterised in that** all the semi-conductor chips (2a, 2b) are disposed in indentations (14).

16. Light-emitting diode as claimed in claim 9 or as claimed in any one of claims 10 to 15 with reference back to claim 9, **characterised in that** the substrate is an electrically conductive substrate by means of which one of the electrical connections of the active layer is produced.

17. Light-emitting diode as claimed in claim 16, **characterised in that** the substrate is a doped SiC substrate.

18. Method for producing a light-emitting diode as claimed in any one of claims 1 to 17, comprising the following method steps:
(a) producing a plurality of lens bodies (3) from SiC, Al₂O₃, glass or a garnet crystal in a wafer composite;
(b) applying conductor tracks (12) for a plurality of semi-conductor chips (2) to the side of the wafer composite, on which the semi-conductor chips are later mounted;
(c) fixing a plurality of semi-conductor chips to the conductor tracks (12), wherein the semi-conductor chips (2) are connected to the conductor tracks (12) on their radiation-permeable electric contact layers (8) by means of laser soldering through the wafer composite; and
(d) dividing the wafer composite into smaller lens body units or into individual lens bodies (3) with semi conductor chips (2),
(e) attaching a cooling body (13) to the lens body (3).

19. Method as claimed in claim 18, wherein between the steps (c) and (d) electrical conductor tracks (22) for electrically connecting rear side contacts (7) of the semi-conductor chips (2) are applied to the wafer composite.

## Revendications

1. Diode luminescente comprenant une puce à semi-conducteur (2) qui présente une couche active (5) émettant des photons, réalisée sur un substrat (4), et, vue depuis le substrat (4), une couche de contact électrique (8) perméable au rayonnement, disposée en aval de la couche active (5),
un corps de lentille transparent (3) pour les photons émis, évacuant la chaleur de dissipation hors de la couche active (5), constitué de SiC, Al₂O₃, de verre ou d'un cristal de grenat étant disposé sur la couche de contact électrique (8) perméable au rayonnement, **caractérisée en ce qu'**un dissipateur de chaleur (13) est placé sur le corps de lentille (3).

2. Diode luminescente selon la revendication 1,
**caractérisée en ce que** le corps de lentille (3) est muni d'un circuit conducteur (12) connectant la couche de contact (8).

3. Diode luminescente selon la revendication 1 ou 2,
**caractérisée en ce que** le corps de lentille (3) présente la forme d'un segment de sphère.

4. Diode luminescente selon l'une quelconque des revendications 1 à 3,
**caractérisée en ce que** le corps de lentille (3) présente une couche anti-réflexion (15) sur une surface lumineuse (11).

5. Diode luminescente selon l'une quelconque des revendications 1 à 3,
**caractérisée en ce qu'**une couche (15)- située sur une surface lumineuse (11) du corps de lentille (3) contient des substances de conversion optiques.

6. Diode luminescente selon l'une quelconque des revendications 1 à 5,
**caractérisée en ce que** la puce à semi-conducteur (2) est placée dans un approfondissement (14) du corps de lentille (3).

7. Diode luminescente selon la revendication 6,
**caractérisée en ce que** des zones (6) de la couche active (5), émettant en direction latérale, sont situées à l'intérieur de l'approfondissement (14) de manière à ce que des photons (17b) partant des zones (6) de la couche active (5), émettant latéralement, injectent dans le corps de lentille (3).

8. Diode luminescente selon l'une quelconque des revendications 1 à 7,
**caractérisée en ce qu'**un côté arrière, tourné vers la puce à semi-conducteur (2), du corps de lentille (3) est argenté au moins en partie.

9. Diode luminescente selon l'une quelconque des revendications 1 à 8,
**caractérisée en ce que** la couche active (5) est fabriquée sur la base de GaₓAl_{y}In_{1-x-y}yN avec 0 ≤ x ≤ 1 , 0 ≤ y ≤ 1 et x+y ≤ 1.

10. Diode luminescente selon l'une quelconque des revendications 1 à 9,
**caractérisée en ce qu'**une pluralité de puces à semi-conducteur (2) sont placées les unes à côté des autres sur le corps de lentille (3).

11. Diode luminescente selon l'une quelconque des revendications 1 à 10,
**caractérisée en ce que** la diode luminescente est munie d'un boîtier (20) qui est équipé d'un filetage (21) pour le vissage dans une douille de lampe.

12. Diode luminescente selon l'une quelconque des revendications 1 à 10,
**caractérisée en ce que** la diode luminescente présente un boîtier (20) pouvant être monté en surface.

13. Diode luminescente selon l'une quelconque des revendications 1 à 12,
**caractérisée en ce que** la puce à semi-conducteur (2) émet entre autres un rayonnement du domaine spectral ultraviolet.

14. Diode luminescente selon l'une quelconque des revendications 1 à 13,
**caractérisée en ce que** la puce à semi-conducteur (2) présente une couche réfléchissante (7) sur le côté opposé au corps de lentille (3).

15. Diode luminescente selon la revendication 10 ou selon l'une quelconque des revendications 11 à 14 en référence à la revendication 10,
**caractérisée en ce que** toutes les puces à semi-conducteur (2a, 2b) sont disposées dans des approfondissements (14).

16. Diode luminescente selon la revendication 9 ou selon l'une quelconque des revendications 10 à 15 en référence à la revendication 9,
**caractérisée en ce que** le substrat est un substrat électro-conducteur par l'intermédiaire duquel l'une des connexions électriques de la couche active est établie.

17. Diode luminescente selon la revendication 16, **caractérisée en ce que** le substrat est un substrat_{.}SiC dopé.

18. Procédé permettant de fabriquer une diode luminescente selon l'une quelconque des revendications 1 à 17, comprenant les étapes de procédé:
(a) fabrication d'une pluralité de corps de lentille (3) en SiC, Al₂O₃, verre ou cristal de grenat en un assemblage de tranches;
(b) pose de circuits conducteurs (12) pour une pluralité de puces à semi-conducteur (2) sur le côté de l'assemblage de tranches, sur lequel les puces à semi-conducteur seront montées ultérieurement;
(c) fixation d'une pluralité de puces à semi-conducteur sur les circuits conducteurs (12), les puces à semi-conducteur (2), sur les couches de contact électriques (8) perméables au rayonnement, étant reliées aux circuits conducteurs (12) au moyen de soudure laser à travers l'assemblage de tranches; et
(d) séparation de l'assemblage de tranches en unités de corps de lentille plus petites ou en corps de lentille individuels (3) comprenant des puces à semi-conducteur (2),
(e) pose d'un dissipateur de chaleur (13) sur le corps de lentille (3).

19. Procédé selon la revendication 18, dans lequel, entre les étapes (c) et (d), des circuits conducteurs électriques (22) sont appliqués sur l'assemblage de tranches pour le raccordement électrique de contacts arrière (7) des puces à semi-conducteur (2).
